# EUROPEAN PATENT APPLICATION

(11) **EP 2 207 209 A1**
(43) Date of publication of application: **14.07.2010**
(21) Application number: 08845475.6
(22) Date of filing: 30.10.2008
(51) Int. Cl.: H01L 31/04

(54) **SOLAR CELL**

(30) Priority: 30.10.2007 JP 2007282519; 21.03.2008 JP 2008074493
(71) Applicant: SANYO Electric Co., Ltd., Moriguchi-shi Osaka 570-8677 (JP)
(72) Inventor: The designation of the inventor has not yet been filed
(74) Representative: Calderbank, Thomas Roger
(86) International application number: PCT/JP2008/069754
(87) International publication number: WO 2009/057692

(57) **Abstract**

A solar cell comprises a light-receiving side electrode layer 2 a rear side electrode layer 4 and a stacked body 3 placed between the light-receiving side electrode layer 2 and the rear side electrode layer 4, wherein the stacked body 3 includes a first photoelectric conversion section 31, and a reflection layer 32 configured to reflect part of light, which is transmitted through the first photoelectric conversion section 31, to the first photoelectric conversion section 31 side, and the reflection layer 32 includes a MgZnO layer 32b made of MgZnO and a contact layer 32a inserted between the MgZnO layer 32b and the first photoelectric conversion section31.

## Description

### TECHNICAL FIELD

The present invention relates to a solar cell which includes a reflection layer configured to reflect part of light incident thereon.

### Background ART

Solar cells are expected as a new source of energy, because solar cells are capable of directly converting light, which comes from the sun as a clean, unlimited source of energy, to electricity.

In general, a solar cell includes a photoelectric conversion section between a transparent electrode layer placed on a light-incident side of the solar cell and a rear side electrode layer placed on the opposite side of the solar cell from the light-incident side. The photoelectric conversion section is configured to absorb light incident on the solar cell and to generate photo-generated carriers.

There has heretofore been known a technique in which a reflection layer configured to reflect part of light incident thereon is placed between a photoelectric conversion section and a rear side electrode layer. Such a reflection layer reflects part of light, which is transmitted through the photoelectric conversion section, to the photoelectric conversion section side. Accordingly, the amount of light which is absorbed in the photoelectric conversion section is increased. As a result, photo-generated carriers, which are generated in the photoelectric conversion section, increase in number. This enhances the photoelectric conversion efficiency of the solar cell.

In general, zinc oxide (ZnO) is used as a transparent electrically-conductive material which is mainly contained in the reflection layer (see Michio Kondo et al., "Four terminal cell analysis of amorphous/microcrystalline Si tandem cell").

In recent years, however, request has been made on further enhancement of the photoelectric conversion efficiency of the solar cell.

Here, increase in number of photo-generated carriers, which are generated in the photoelectric conversion section, is effective for further enhancement the photoelectric conversion efficiency. For this reason, if the reflectance of light at the reflection layer is increased, it is possible to enhance the photoelectric conversion efficiency.

The present invention has been made with this problem taken into consideration. An object of the present invention is to provide a solar cell whose photoelectric conversion efficiency is enhanced.

### DISCLOSURE OF THE INVENTION

The solar cell according to one characteristic of the present invention, is summarized as comprising a light-receiving side electrode layer which is electrically-conductive and transparent; a rear side electrode layer which is electrically-conductive; and a stacked body placed between the light-receiving side electrode layer and the rear side electrode layer, wherein the stacked body includes a first photoelectric conversion section configured to generate photo-generated carriers on the basis of light incident thereon, and a reflection layer configured to reflect part of light, which is transmitted through the first photoelectric conversion section, to the first photoelectric conversion section side, and the reflection layer includes a low-refractive-index layer and a contact layer inserted between the low-refractive-index layer and the first photoelectric conversion section.

In the solar cell according to the one characteristic of the present invention, the reflection layer includes the low-refractive-index layer whose refractive index is low. This can increase the reflectance of the reflection layer. In addition, the reflection layer includes the contact layer which is inserted between the low-refractive-index layer and the first photoelectric conversion section. This avoids direct contact of the low-refractive-index layer with the first photoelectric conversion section. This kind of configuration is capable of enhancing the reflectance of the reflection layer while inhibiting reduction in the fill factor (F.F.) of the solar cell through increase in the series resistance value of the solar cell as a whole. Accordingly, it is possible to enhance the photoelectric conversion efficiency of the solar cell.

In the one characteristic of the present invention, the stacked body may have a configuration in which the first photoelectric conversion section, the reflection layer and a second photoelectric conversion section are sequentially stacked from the light-receiving side electrode layer side, the second photoelectric conversion section being configured to generate photo-generated carriers on the basis of light incident thereon, and the reflection layer further includes a different contact layer which is inserted between the low-refractive-index layer and the second photoelectric conversion section.

In addition, the different contact layer may be made of a material which makes a contact resistance value between the different contact layer and the second photoelectric conversion section smaller than a contact resistance value between the low-refractive-index layer and the second photoelectric conversion section.

In the one characteristic of the present invention, the contact layer may be made of a material which makes a contact resistance value between the contact layer and the first photoelectric conversion section smaller than a contact resistance value between the low-refractive-index layer and the first photoelectric conversion section.

In the one characteristic of the present invention, the low-refractive-index layer may be made of a transparent electrically-conductive oxide whose refractive index is not less than 1.7 but not more than 1.9. In specific, it is desirable that the low-refractive-index layer is made of a transparent electrically-conductive oxide whose refractive index is not less than 1.7 but not more than 1.85.

In the one characteristic of the present invention, the low-refractive-index layer may be made of MgZnO.

In the one characteristic of the present invention, the contact layer may contain any one of zinc oxide and indium oxide.

In the one characteristic of the present invention, the different contact layer may contain any one of zinc oxide and indium oxide.

The solar cell according to the one characteristic of the present invention, is summarized that A solar cell which includes a first solar cell element and a second solar cell element on a substrate which is electrically-insulating and transparent, wherein each of the first solar cell element and the second solar cell element includes a light-receiving side electrode layer which is electrically-conductive and transparent, a rear side electrode layer which is electrically-conductive, and a stacked body placed between the light-receiving side electrode layer and the rear side electrode layer, the stacked body includes a first photoelectric conversion section configured to generate photo-generated carriers on the basis of light incident thereon, a reflection layer configured to reflect part of light, which is transmitted through the first photoelectric conversion section, to the first photoelectric conversion section side, and a second photoelectric conversion section configured to generate photo-generated carriers on the basis of light incident thereon, the rear side electrode layer of the first solar cell element includes an extension section which extends to the light-receiving side electrode layer of the second solar cell element, the extension section is formed along a side surface of the stacked body included in the first solar cell element, the extension section is in contact with the reflection layer which is exposed from the side surface of the stacked body included in the first solar cell element, and the reflection layer includes a low-refractive-index layer, a contact layer inserted between the low-refractive-index layer and the first photoelectric conversion section, and a different contact layer inserted between the low-refractive-index layer and the second photoelectric conversion section.

In the one characteristic of the present invention, the contact layer may have a thickness which is less than that of the low-refractive-index layer.

In the one characteristic of the present invention, the low-refractive-index layer may be made of MgZnO.

In the one characteristic of the present invention, a Mg content of the MgZnO layer may be larger than 0at% but not larger than 25at%.

### BRIEF DESCRIPTION OF THE DRAWINGS

[Fig. 1] Fig. 1 is a cross-sectional view of a solar cell 10 according to a first embodiment of the present invention.
[Fig. 2] Fig. 2 is a cross-sectional view of a solar cell 10 according to a second embodiment of the present invention.
[Fig. 3] Fig. 3 is a cross-sectional view of a solar cell 10 according to a third embodiment of the present invention.
[Fig. 4] Fig. 4 is a cross-sectional view of a solar cell 10 according to a fourth embodiment of the present invention.
[Fig. 5] Fig. 5 is a cross-sectional view of a solar cell 20 according to Comparative Example 1 and Comparative Example 2 of the present invention.
[Fig. 6] Fig. 6 is a cross-sectional view of a solar cell 30 according to Comparative Example 3 of the present invention.
[Fig. 7] Fig. 7 is a diagram showing a relationship between a Mg content and a light absorption coefficient of a MgZnO layer.
[Fig. 8] Fig. 8 is a diagram showing a relationship between the Mg content and a refractive index of the MgZnO layer.

### BEST MODES FOR CARRYING OUT THE INVENTION

Next, descriptions will be provided for embodiments of the present invention by use of the drawings. Throughout descriptions of the following drawings, the same or similar parts are denoted by the same or similar reference signs. Note that the drawings are schematic and ratios between or among dimensions and the like are different from real ones. Specific dimensions and the like shall be judged by taking the following descriptions into consideration. Furthermore, it is a matter of course that the drawings include parts whose dimensional relationships and ratios are different among the drawings.

### [First Embodiment]

### <Configuration of Solar Cell>

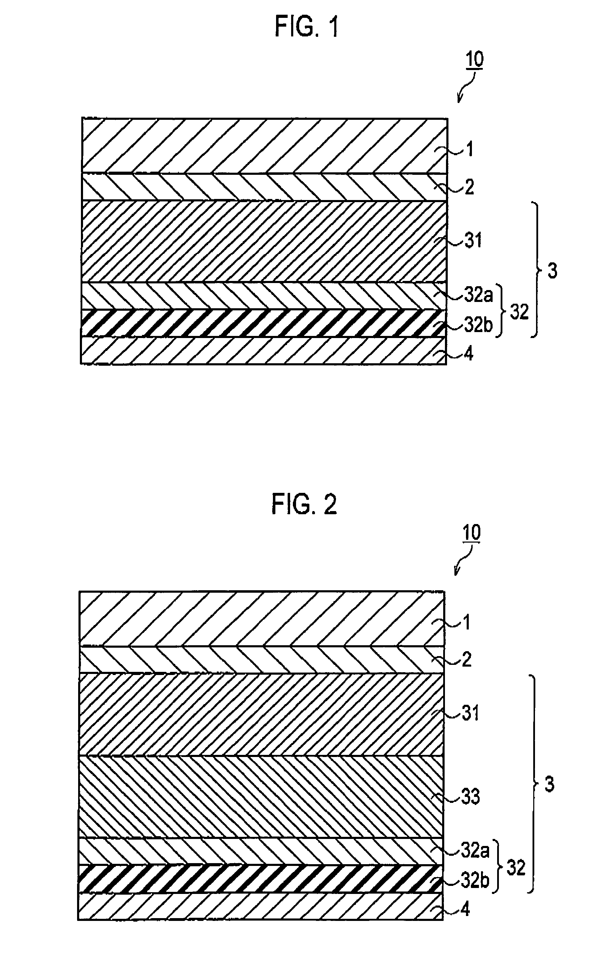

Referring to Fig. 1, descriptions will be hereinbelow provided for a configuration of a solar cell according to a first embodiment of the present invention.

Fig. 1 is a cross-sectional view of the solar cell 10 according to the first embodiment of the present invention.

As shown in Fig. 1, the solar cell 10 includes a substrate 1, a light-receiving side electrode layer 2, a stacked body 3 and a rear side electrode layer 4.

The substrate 1 is transparent, and is made of a transparent material such as glass or plastic.

The light-receiving side electrode layer 2 is stacked on the substrate, and is electrically-conductive and transparent. A metal oxide, such as tin oxide (SnO₂), zinc oxide (ZnO), indium oxide (In₂O₃) or titanium oxide (TiO₂), may be used for the light-receiving side electrode layer 2. Note that these metal oxides may be doped with fluorine (F), tin (Sn), aluminum (Al), iron (Fe), gallium (Ga), niobium (Nb) or the like.

The stacked body 3 is placed between the light-receiving side electrode layer 2 and the rear side electrode layer 4. The stacked body 3 includes a first photoelectric conversion section 31 and a reflection layer 32.

The first photoelectric conversion section 31 and the reflection layer 32 are sequentially stacked from the light-receiving side electrode layer 2 side.

The first photoelectric conversion section 31 generates photo-generated carriers on the basis of light incident thereon from the light-receiving side electrode layer 2 side. In addition, the first photoelectric conversion section 31 generates photo-generated carriers on the basis of light reflected off the reflection layer 32. The first photoelectric conversion section 31 has a pin junction in which a p-type amorphous silicon-based semiconductor, an i-type amorphous silicon-based semiconductor and an n-type amorphous silicon-based semiconductor are stacked from the substrate 1 side (not illustrated).

The reflection layer 32 reflects part of light, which is transmitted through the first photoelectric conversion section 31, to the first photoelectric conversion section 31 side. The reflection layer 32 includes a first layer 32a and a second layer 32b.

The first layer 32a and the second layer 32b are sequentially stacked from the first photoelectric conversion section 31 side. Thus, the first layer 32a is in contact with the first photoelectric conversion section 31. The second layer 32b is not in contact with the first photoelectric conversion section 31.

A material mainly used for the first layer 32a is one which makes the contact resistance value between the first layer 32a and the first photoelectric conversion section 31 smaller than the contact resistance value between the second layer 32b and the first photoelectric conversion section 31.

In other words, it is desirable that the material for the first layer 32a should be selected so that the contact resistance value between the first photoelectric conversion section 31 and the first layer 32a may be smaller than the contact resistance value which would be obtained if the first photoelectric conversion section 31 and the second layer 32b were brought in direct contact with each other.

For instance, ZnO, ITO or the like may be used for the first layer 32a.

The second layer 32b is a transparent electrically-conductive oxide made of a material whose refractive index is lower than that of the material for each of the first photoelectric conversion section 31 and the first layer 32a. In addition, the second layer 32b is made of the material whose refractive index is lower than that of ZnO which has been heretofore mainly used for reflection layers. The refractive index of the second layer 32b should desirably be not lower than 1. 7 but not higher than 1.9, and more desirably, not lower than 1.7 but not higher than 1.85.

In the case of the first embodiment, the second layer 32b contains magnesium zinc oxide (MgZnO). The second layer 32b may be doped with Al or the like. The Mg content of the second layer 32b is larger than 0at% but not larger than 25at%.

Note that the first layer 32a according to the first embodiment of the present invention corresponds to the "contact layer" of the present invention. Furthermore, the second layer 32b corresponds to the "low-refractive-index layer" of the present invention.

Moreover, it is desirable that the material for the first layer 32a should be selected so that the resistance value of the two ends of the stacked body 3 inclusive of the first layer 32a would be smaller than the resistance value of the two ends of the stacked body 3 exclusive of the first layer 32a.

The rear side electrode layer 4 is electrically-conductive. ZnO, silver (Ag) or the like may be used for the rear side electrode layer 4. However, the material for the rear side electrode layer 4 is not limited to these substances. The rear side electrode layer may have a configuration in which a layer containing ZnO and a layer containing Ag are sequentially stacked from the stacked body 3 side. Alternately, the rear side electrode layer 4 may have only a layer containing Ag.

### <Advantageous Effects>

In the case of the solar cell 10 according to the first embodiment of the present invention, the reflection layer 32 includes: the second layer 32b made of MgZnO, whose refractive index is low; and the first layer 32a made of the material which makes the contact resistance value between the first layer 32a and the first photoelectric conversion section 31 smaller than the contact resistance value between the second layer 32b and the first photoelectric conversion section 31. The first layer 32a and the second layer 32b are sequentially stacked from the first photoelectric conversion section 31 side. For this reason, the second layer 32b, whose refractive index is low, is not in direct contact with the first photoelectric conversion section 31. This can enhance the photoelectric conversion efficiency of the solar cell 10. Effects achieved by this configuration will be hereinbelow described in detail.

In the case of the solar cell 10 according to the first embodiment of the present invention, the reflection layer 32 includes the second layer 32b made of MgZnO whose refractive index is lower than that of ZnO which has been heretofore mainly used for reflection layers. This can make the difference in refractive index between the first photoelectric conversion section 31 and the reflection layer 32 larger than the difference in refractive index between the first photoelectric conversion section 31 and any conventional reflection layer made mainly of ZnO. Accordingly, it is possible to increase the reflectance of the reflection layer 32.

Here, if the reflection layer 32 did not include the first layer 32a, or if the first layer 32a and the second layer 32b were sequentially stacked from the rear side electrode layer 4 side, the second layer 32b would be in direct contact with the first photoelectric conversion section 31. Generally speaking, to decrease the refractive index of the reflection layer 32, the bandgap of the reflection layer 32 needs to increased. However, in general, when the bandgap is increased, the resistance is apt to increase. Thus, the increased bandgap extremely increases the contact resistance value between the second layer 32b, whose refractive index is low, and the first photoelectric conversion section 31 made mainly of silicon. For this reason, if the second layer 32b was in direct contact with the first photoelectric conversion section 31, the series resistance value of the solar cell 10 as a whole would become higher. Accordingly, a short-circuit current which occurs in the solar cell 10 would increase due to the increased refractive index of the reflection layer 32. On the other hand, the fill factor (F.F.) of the solar cell 10 would decrease due to the increased series resistance value. These would make it impossible to sufficiently enhance the photoelectric conversion efficiency of the solar cell 10.

With this taken into consideration, in the case of the solar cell 10 according to the first embodiment of the present invention, the first layer 32a and the second layer 32b are sequentially stacked from the first photoelectric conversion section 31 side. This avoids direct contact of the second layer 32b, whose refractive index is low, with the first photoelectric conversion section 31. This kind of configuration can enhance the reflectance of the reflection layer 32 while inhibiting the decrease in the fill factor (F.F.) of the solar cell 10 which would otherwise occur due to the increased series resistance value of the whole solar cell 10. This makes it possible to enhance the photoelectric conversion efficiency of the solar cell 10.

In addition, the Mg content of the second layer 32b is larger than 0at% but not larger than 25at%. This allows the light absorption coefficient of the second layer 32b in a wavelength range of, for instance, 700 to 800 nm to be lower than that of any conventional reflection layer made mainly of ZnO. Accordingly, it is possible to increase the amount of light reflected to the first photoelectric conversion section 33 side, and thus to increase the short-circuit current in the solar cell 10. This makes it possible to further enhance the photoelectric conversion efficiency of the solar cell 10.

Furthermore, in a case where the refractive index of the second layer 32b is not lower than 1.7 but not higher than 1.9, particularly, not lower than 1.7 but not higher than 1.85, it is possible to obtain sufficient reflectance properties of the reflection layer 32.

Moreover, it is desirable that the thickness of the first layer 32a should be not less than approximately 10 Å but not more than approximately 80 Å. In a case where the thickness of the first layer 32a is less than approximately 10 Å, it is impossible to sufficiently reduce the contact resistance between the second layer 32b and the first photoelectric conversion section 31. On the contrary, in a case where the thickness of the first layer 32a is more than approximately 80 Å, this thickness reduces the effect which the inclusion of the second layer 32b brings about, namely the effect of enhancing the reflectance of the reflection layer 32.

### [Second Embodiment]

Descriptions will be hereinbelow provided for a second embodiment of the present invention. Note that the following descriptions will be provided mainly for what makes the second embodiment different from the above-described first embodiment.

Specifically, in the case of the first embodiment, the stacked body 3 includes the first photoelectric conversion section 31 and the reflection layer 32.

By contrast, in the case of the second embodiment, the stacked body 3 includes a second photoelectric conversion section 33 in addition to the first photoelectric conversion section 31 and the reflection layer 32. In other words, the solar cell according to the second embodiment has a tandem structure.

### <Configuration of Solar Cell>

Referring to Fig. 2, descriptions will be hereinbelow provided for a configuration of the solar cell according to the second embodiment of the present invention.

Fig. 2 is a cross-sectional view of the solar cell 10 according to the second embodiment of the present invention.

As shown in Fig. 2, the solar cell 10 includes the substrate 1, the light-receiving side electrode layer 2, the stacked body 3 and the rear side electrode layer 4.

The stacked body 3 is placed between the light-receiving side electrode layer 2 and the rear side electrode layer 4. The stacked body 3 includes the first photoelectric conversion section 31, the reflection layer 32, and the second photoelectric conversion section 33.

The first photoelectric conversion section 31, the second photoelectric conversion section 33 and the reflection layer 32 are sequentially stacked from the light-receiving side electrode layer 2 side.

The first photoelectric conversion section 31 generates photo-generated carriers on the basis of light incident from the light-receiving side electrode layer 2 side. The first photoelectric conversion section 31 has a pin junction in which a p-type amorphous silicon-based semiconductor, an i-type amorphous silicon-based semiconductor and an n-type amorphous silicon-based semiconductor are stacked from the substrate 1 side (not illustrated).

The reflection layer 32 reflects part of light, which is incident from the first photoelectric conversion section 31 side, to the first photoelectric conversion section 31 side. The reflection layer 32 includes the first layer 32a and the second layer 32b. The first layer 32a and the second layer 32b are sequentially stacked from the first photoelectric conversion section 31 side. Accordingly, the first layer 32a is in contact with the second photoelectric conversion section 33, and the second layer 32b is not in contact with the second photoelectric conversion section 33.

The second layer 32b is a transparent electrically-conductive oxide made of a material whose refractive index is lower than that of the material for the first photoelectric conversion section 31. Furthermore, in the case of the second embodiment, too, the refractive index of the second layer 32b should desirably be not lower than 1.7 but not higher than 1.9, and more desirably, not lower than 1.7 but not higher than 1.85. The Mg content of the second layer 32b made of MgZnO should desirably be higher than 0at% but not higher than 25at%.

The second photoelectric conversion section 33 generates photo-generated carriers on the basis of light incident thereon. The second photoelectric conversion section 33 has a pin junction in which a p-type crystalline silicon-based semiconductor, an i-type crystalline silicon-based semiconductor and an n-type crystalline silicon-based semiconductor are stacked from the substrate 1 side (not illustrated).

### <Advantageous Effects>

In the case of the solar cell 10 according to the second embodiment of the present invention, the first layer 32a and the second layer 32b, which are included in the reflection layer 32, are sequentially stacked from the first photoelectric conversion section 31 side (not illustrated).

Although the solar cell 10 has the tandem structure, this kind of configuration can enhance the reflectance of the reflection layer 32 while inhibiting the increase in the series resistance value of the solar cell 10 as a whole. Accordingly, it is possible to enhance the photoelectric conversion efficiency of the solar cell 10.

In addition, the Mg content of the second layer 32b is larger than 0at% but not larger than 25at%. This allows the light absorption coefficient of the second layer 32b in a wavelength range of, for instance, 900 to 1000 nm to be lower than that of any conventional reflection layer made mainly of ZnO. Accordingly, it is possible to increase the amount of light incident on the second photoelectric conversion section 33, and thus to increase the short-circuit current in the solar cell 10. This makes it possible to further enhance the photoelectric conversion efficiency of the solar cell 10.

Furthermore, in the case where the refractive index of the second layer 32b is not lower than 1.7 but not higher than 1.9, particularly, not lower than 1.7 but not higher than 1.85, it is possible to obtain sufficient reflectance properties of the reflection layer 32.

Moreover, it is desirable that the thickness of the first layer 32a should be not less than approximately 10 Å but not more than approximately 80 Å. In the case where the thickness of the first layer 32a is less than approximately 10 Å, it is impossible to sufficiently reduce the contact resistance between the second layer 32b and the first photoelectric conversion section 31. On the contrary, in the case where the thickness of the first layer 32a is more than approximately 80 Å, this thickness reduces the effect which the inclusion of the second layer 32b brings about, namely the effect of enhancing the reflectance of the reflection layer 32.

### [Third Embodiment]

Descriptions will be hereinbelow provided for a third embodiment of the present invention. Note that the following descriptions will be provided mainly for what makes the third embodiment different from the above-described first embodiment.

Specifically, in the case of the first embodiment, the stacked body 3 includes the first photoelectric conversion section 31 and the reflection layer 32.

By contrast, in the case of the third embodiment, the stacked body 3 includes the second photoelectric conversion section 33 in addition to the first photoelectric conversion section 31 and the reflection layer 32. In other words, the solar cell according to the third embodiment has a tandem structure. Moreover, in the case of the third embodiment, the reflection layer 32 includes a third layer 32c in addition to the first layer 32a and the second layer 32b.

### <Configuration of Solar Cell>

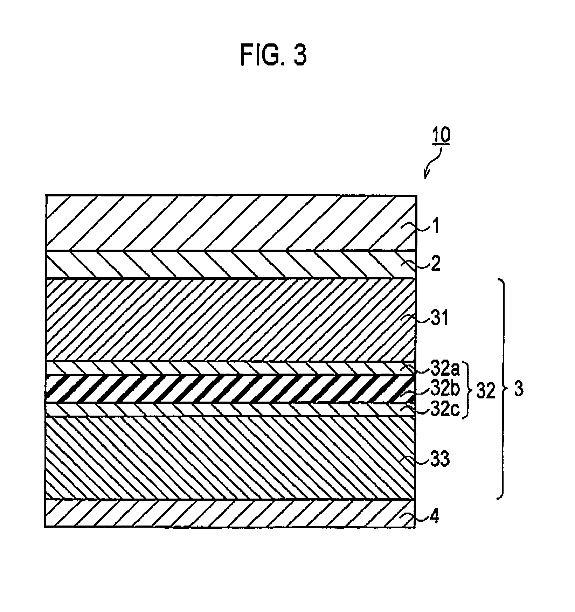

Referring to Fig. 3, descriptions will be hereinbelow provided for a configuration of the solar cell according to the third embodiment of the present invention.

Fig. 3 is a cross-sectional view of the solar cell 10 according to the third embodiment of the present invention.

As shown in Fig. 3, the solar cell 10 includes the substrate 1, the light-receiving side electrode layer 2, the stacked body 3 and the rear side electrode layer 4.

The stacked body 3 is placed between the light-receiving side electrode layer 2 and the rear side electrode layer 4. The stacked body 3 includes the first photoelectric conversion section 31, the reflection layer 32, and the second photoelectric conversion section 33.

The first photoelectric conversion section 31, the reflection layer 32 and the second photoelectric conversion section 33 are sequentially stacked from the light-receiving side electrode layer 2 side.

The first photoelectric conversion section 31 generates photo-generated carriers on the basis of light incident from the light-receiving side electrode layer 2 side. In addition, the first photoelectric conversion section 31 generates photo-generated carriers on the basis of light reflected off the reflection layer 32. The first photoelectric conversion section 31 has a pin junction in which a p-type amorphous silicon-based semiconductor, an i-type amorphous silicon-based semiconductor and an n-type amorphous silicon-based semiconductor are stacked from the substrate 1 side (not illustrated).

The reflection layer 32 reflects part of light, which is transmitted through the first photoelectric conversion section 31, to the first photoelectric conversion section 31 side. The reflection layer 32 includes the first layer 32a, the second layer 32b and the third layer 32c.

The first layer 32a, the second layer 32b and the third layer 32c are sequentially stacked from the first photoelectric conversion section 31 side. Accordingly, the first layer 32a is in contact with the first photoelectric conversion section 31, and the third layer 32c is in contact with the second photoelectric conversion section 33. The second layer 32b is in contact with neither the first photoelectric conversion section 31 nor the second photoelectric conversion section 33.

The second layer 32b is a transparent electrically-conductive oxide made of a material whose refractive index is lower than that of the material for each of the first photoelectric conversion section 31, the second photoelectric conversion section 33, the first layer 32a and the third layer 32c. Furthermore, the second layer 32b is made of the material whose refractive index is lower than that of ZnO which has been heretofore mainly used for reflection layers. The refractive index of the second layer 32b should desirably be not lower than 1. 7 but not higher than 1. 9, and more desirably, not lower than 1.7 but not higher than 1.85.

In the case of the third embodiment, the second layer 32b contains magnesium zinc oxide (MgZnO). The second layer 32b may be doped with Al or the like. It is desirable that the Mg content of the second layer 32b should be higher than 0at% but not higher than 25at%.

A material mainly used for the first layer 32a is one which makes the contact resistance value between the first layer 32a and the first photoelectric conversion section 31 smaller than the contact resistance value between MgZnO and the first photoelectric conversion section 31. In addition, a material mainly used for the third layer 32c is one which makes the contact resistance value between the third layer 32c and the second photoelectric conversion section 33 smaller than the contact resistance value between MgZnO and the first photoelectric conversion section 31.

In other words, it is desirable that the material for the first layer 32a should be selected so that the contact resistance value between the first photoelectric conversion section 31 and the first layer 32a would be smaller than the contact resistance value which would be obtained if the first photoelectric conversion section 31 and the second layer 32b were brought in direct contact with each other. In addition, it is desirable that the material for the third layer 32c should be selected so that the contact resistance value between the third layer 32c and the second photoelectric conversion section 33 would be smaller than the contact resistance value which would be obtained if the second layer 32b and the second photoelectric conversion section 33 were brought in direct contact with each other.

Moreover, it is desirable that the material for the first layer 32a and the material for the third layer 32c should be selected so that the resistance value of the two ends of the stacked body 3 inclusive of the first layer 32a and the third layer 32c would be smaller than the resistance value of the two ends of the stacked body 3 exclusive of the first layer 32a and the third layer 32c.

For instance, ZnO, ITO or the like may be used for the first layer 32a and the third layer 32c. Note that the material for the first layer 32a and the material for the third layer 32c may be the same, or may be different from each other.

Note that the third layer 32c according to the first embodiment of the present invention corresponds to the "different contact layer" according to the present invention.

The second photoelectric conversion section 33 generates photo-generated carriers on the basis of light incident thereon. The second photoelectric conversion section 33 has a pin junction in which a p-type crystalline silicon-based semiconductor, an i-type crystalline silicon-based semiconductor and an n-type crystalline silicon-based semiconductor are stacked from the substrate 1 side (not illustrated).

### <Advantageous Effects>

In the case of the solar cell 10 according to the third embodiment of the present invention, the reflection layer 32 includes: the first layer 32a made of the material whose refractive index is higher than that of the material for the second layer 32b; the second layer 32b made of MgZnO, whose refractive index is low; the first layer 32a made of the material which makes the contact resistance value between the first layer 32a and the first photoelectric conversion section 31 smaller than the contact resistance value between the second layer 32b and the first photoelectric conversion section 31; and the third layer 32a made of the material which makes the contact resistance value between the third layer 32c and the second photoelectric conversion section smaller than the contact resistance value between the second layer 32b and the second photoelectric conversion section 33. The first layer 32a, the second layer 32b and the third layer 32c are sequentially stacked from the first photoelectric conversion section 31 side. For this reason, the second layer 32b, which contains MgZnO, is in contact with neither the first photoelectric conversion section 31 nor the second photoelectric conversion section 33.

This kind of configuration can enhance the reflectance of the reflection layer 32 while inhibiting the increase in the series resistance value of the solar cell 10 as a whole. Accordingly, it is possible to increase the amount of light which is absorbed in the first photoelectric conversion section 31.

In addition, the Mg content of the second layer 32b is larger than 0at% but not larger than 25at%. This allows the light absorption coefficient of the second layer 32b in a wavelength range of, for instance, 900 to 1000 nm to be lower than that of any conventional reflection layer made mainly of ZnO. Accordingly, it is possible to increase the amount of light incident on the second photoelectric conversion section 33, and thus to increase the short-circuit current in the solar cell 10. This makes it possible to further enhance the photoelectric conversion efficiency of the solar cell 10. As a result, it is possible to enhance the photoelectric conversion efficiency of the solar cell 10.

Furthermore, in the case where the refractive index of the second layer 32b is not lower than 1.7 but not higher than 1.9, particularly, not lower than 1. 7 but not higher than 1.85, it is possible to obtain sufficient reflectance properties of the reflection layer 32.

Moreover, it is desirable that the thickness of each of the first layer 32a and the third layer 32c should be not less than approximately 10 Å but not more than approximately 80 Å. In the case where the thickness of each of the first layer 32a and the third layer 32c is less than approximately 10 Å, it is impossible to sufficiently reduce the contact resistance between the second layer 32b and the first photoelectric conversion section 31 as well as the contact resistance between the second layer 32b and the second photoelectric conversion section 33. On the contrary, in a case where the thickness of each of the first layer 32a and the third layer 32c is more than approximately 80 Å, this thickness reduces the effect which the inclusion of the second layer 32b brings about, namely the effect of enhancing the reflectance of the reflection layer 32.

### [Fourth Embodiment]

Descriptions will be hereinbelow provided for a fourth embodiment of the present invention. The following descriptions will be provided mainly for what makes the fourth embodiment different from the above-described third embodiment.

Specifically, in the case of the third embodiment, the solar cell 10 includes the substrate 1, the light-receiving side electrode layer 2, the stacked body 3, and the rear side electrode layer 4.

By contrast, in the case of the fourth embodiment, the solar cell 10 has multiple solar cell elements 10a on the substrate 1. Each solar cell element 10a includes the light-receiving side electrode layer 2, the stacked body 3 and the rear side electrode layer 4.

### <Configuration of Solar Cell>

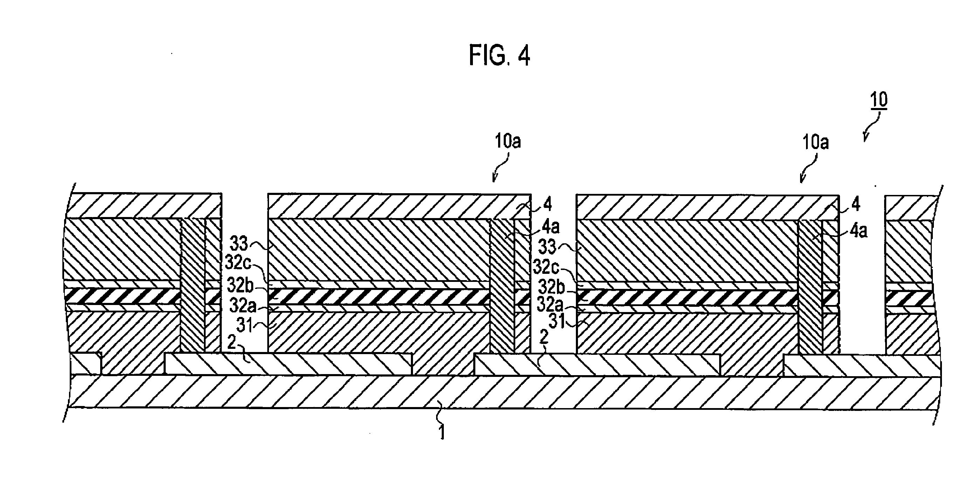

Referring to Fig. 4, descriptions will be hereinbelow provided for the solar cell according to the fourth embodiment of the present invention.

Fig. 4 is a cross-sectional view of the solar cell 10 according to the fourth embodiment of the present invention.

As shown in Fig. 4, the solar 10 includes the substrate 1 and the multiple solar cell elements 10a.

Each of the multiple solar cell elements 10a is formed on the substrate 1. The multiple solar cells 10a each include the light-receiving side electrode layer 2, the stacked body 3 and the rear side electrode layer 4.

The stacked body 3 is placed between the light-receiving side electrode layer 2 and the rear side electrode layer 4. The stacked body 3 includes the first photoelectric conversion section 31, the reflection layer 32 and the second photoelectric conversion section 33. The reflection layer 32 includes the first layer 32a, the second layer 32b and the third layer 32c.

The first layer 32a, the second layer 32b and the third layer 32c are sequentially stacked from the first photoelectric conversion section 31 side. Accordingly, the first layer 32a is in contact with the first photoelectric conversion section 31, and the third layer 32c is in contact with the second photoelectric conversion section 33. The second layer 32b is in contact with neither the first photoelectric conversion section 31 nor the second photoelectric conversion section 33. It is desirable that the thickness of each of the first layer 32a and the third layer 32c should be as thin as possible.

The rear side electrode 4 of any one solar cell element 10a, which is included in the multiple solar cell elements 10a, includes an extension section 4a which extends to the light-receiving electrode layer 2 of another solar cell element 10a adjacent to the one solar cell element 10a.

The extension section 4a is formed along a side surface of the stacked body 3 included in the one solar cell element 10a. The extension section 4a is in contact with the reflection layer 32 which is exposed from the side surface of the stacked body 3 included in the one solar cell element 10a.

### <Advantageous Effects>

In the case of the solar cell 10 according to the fourth embodiment of the present invention, it is possible to enhance the reflectance of the reflection layer 32, and to inhibit the decrease in the fill factor (F.F.) of the solar cell 10. This makes it possible to enhance the photoelectric conversion efficiency of the solar cell 10. Detailed descriptions will be hereinbelow provided for such effects.

A sheet resistance value of ZnO which has been heretofore mainly used for reflection layers is approximately 1.0×10² to 1.0×10³ Ω/□. For this reason, in a case where a conventional reflection layer made mainly of ZnO is used, part of an electric current which occurs in the solar cell element 10a flows to the extension section 4a along this reflection layer. As a result, a leakage current occurs. If such a leakage current increases in each of the multiple solar cell elements 10a, the fill factor (F.F.) of the solar cell 10 reduces.

With this taken into consideration, in the case of the solar cell 10 according to the fourth embodiment of the present invention, the reflection layer 32 includes the second layer 32b made of MgZnO, whose sheet resistance value is not smaller than 1.0×10⁶ Ω/□. This kind of configuration makes the sheet resistance value of the reflection layer 32 significantly higher than the sheet resistance value of the conventional reflection layer made mainly of ZnO, and thus makes it possible to suppress the flow of an electric current, which occurs in the solar cell element 10a, from the reflection layer 32 directly to the extension section 4a. Accordingly, the reduction in the fill factor (F.F.) of the solar cell 10 can be more inhibited when the reflection layer 32 including the second layer 32b is used than when the conventional reflection layer made mainly of ZnO is used. For this reason, it is possible to enhance the photoelectric conversion efficiency of the solar cell 10.

Moreover, the first layer 32a (the contact layer) aims at reducing the contact resistance value between the second layer 32b (the MgZnO layer) and the first photoelectric conversion section 31, and the third layer 32c (the different contact layer) aims at reducing the contact resistance value between the second layer 32b (the low-refractive-index layer) and the second photoelectric conversion section 33. For this reason, the thickness of each of the first layer 32a and the third layer 32c can be made thin.

When the thickness of the first layer 32a is reduced, it is possible to increase the sheet resistance value of the first layer 32a. In addition, when the thickness of the third layer 32c is reduced, it is possible to increase the sheet resistance value of the third layer 32c. Here, even when the thickness of the first layer 32a is reduced, it is possible to sufficiently reduce the contact resistance value between the second layer 32b (the MgZnO layer) and the first photoelectric conversion section 31. Furthermore, even when the thickness of the first layer 32a is reduced, it is possible to sufficiently reduce the contact resistance value between the second layer 32b (the MgZnO layer) and the first photoelectric conversion section 31. For these reasons, when the thickness of each of the first layer 32a and the third layer 32c is reduced as much as possible, it is possible to reduce a leakage current which flows to the extension section 4a along each of the first layer 32a and the third layer 32c.

Moreover, it is desirable that the thickness of each of the first layer 32a and the third layer 32c should be not less than approximately 10 Å but not more than 80 Å. In a case where the thickness of each of the first layer 32a and the third layer 32c is less than approximately 10 Å, it is impossible to sufficiently reduce the contact resistance between the second layer 32b and the first photoelectric conversion section 31 as well as the contact resistance between the second layer 32b and the second photoelectric conversion section 33. Further, in a case where the thickness of each of the first layer 32a and the third layer 32c is more than approximately 80 Å, this thickness reduces the effect which the inclusion of the second layer 32b brings about, namely the effect of enhancing the reflectance of the reflection layer 32.

In addition, in a case where the refractive index of the second layer 32b is not smaller than 1.7 but not higher than 1.9, particularly, not smaller than 1.7 but not higher than 1.85, it is possible to obtain sufficient reflectance properties of the reflection layer 32.

### <Other Embodiments>

Although the present invention has been described on the basis of the foregoing embodiments, the descriptions and drawings, which constitute this disclosure, shall not be construed as imposing any limitation on this invention. To those skilled in the art, various alternative embodiments, examples and operating techniques will be clear from this disclosure.

For instance, in the above-described first embodiment, the number of photoelectric conversion sections included in the stacked body 3 is one (the first photoelectric conversion section 31). In the case of the second and third embodiments, the number of photoelectric conversion sections included in the stacked body 3 is two (the first photoelectric conversion section 31 and the second photoelectric conversion section 33). However, the number of photoelectric conversion sections is not limited to these numbers. Specifically, it may be possible to include three or more photoelectric conversion sections. In this case, the reflection layer 32 may be placed between any two adjacent photoelectric conversion sections.

Furthermore, in the case of the above-described first embodiment, the first photoelectric conversion section 31 has the pin junction in which the p-type amorphous silicon-based semiconductor, the i-type amorphous silicon-based semiconductor and the n-type amorphous silicon-based semiconductor are stacked from the substrate 1 side. However, the junction type is not limited to this pin junction. Specifically, the first electric conversion section 31 may have a different pin junction in which a p-type crystalline silicon-based semiconductor, an i-type crystalline silicon-based semiconductor and an n-type crystalline silicon-based semiconductor are stacked from the substrate 1 side. Note that crystalline silicon includes microcrystalline silicon and polycrystalline silicon.

Moreover, in the above-described first to fourth embodiments, each of the first photoelectric conversion section 31 and the second photoelectric conversion section 33 has the pin junction. However, the junction type is not limited to the pin junction. Specifically, at least one of the first photoelectric conversion section 31 and the second photoelectric conversion section 33 may have a pn junction in which a p-type silicon-based semiconductor and an n-type silicon-based semiconductor are stacked from the substrate 1 side.

Further, in the above-described first to fourth embodiments, the solar cell 10 has the configuration in which the light-receiving side electrode layer 2, the stacked body 3 and the rear side electrode layer 4 are sequentially stacked on the substrate 1. However, the configuration is not limited to this configuration. Specifically, the solar cell 10 may have a configuration in which the rear side electrode layer 4, the stacked body 3 and the light-receiving side electrode layer 2 are sequentially stacked on the substrate 1.

It is a matter of course that the present invention includes various embodiments and the like, which have not been described herein, as explained above. Therefore, the technical scope of the present invention shall be determined solely on the basis of the matters to define the invention according to the scope of claims reasonably understood from the above description.

### Examples

Detailed descriptions will be hereinbelow provided for the solar cell according to the present invention by citing examples. Note that the present invention is not limited to what will be shown in the following examples and that the present invention may be carried out by making modifications whenever deemed necessary within the scope not departing from the gist of the present invention.

### [Evaluation of Refractive Index]

First of all, comparison was made between the refractive index of MgZnO and the refractive index of ZnO which has been heretofore mainly used for reflection layers.

Specifically, a MgZnO layer and a ZnO layer were produced by sputtering. Subsequently, the refractive indices of the respective layers were measured. Table 1 shows conditions for forming the MgZnO layer and the ZnO layer. In addition, Table 2 shows results of measuring the refractive indices of the respective layers.

**[Table 1]**

| Conditions for Forming MgZnO Layer and ZnO Layer | | | | | | |
|---|---|---|---|---|---|---|
| | Target material | Substrate temperature (°C) | Gas flow rate (sccm) | Reaction pressure (Pa) | RF power (W) | Thickness (mm) |
| MgZnO layer | MgZnO (Mg:10-30at%) (Al-doped) | 170 to 230 | Ar:10 | 0.4 | 300 to 400 | 100 |
| ZnO layer | ZnO (Al-doped or Ga-doped) | 170 to 230 | Ar:10 | 0.4 | 300 to 400 | 100 |

**[Table 2]**

| Refractive Indices of MgZnO Layer and ZnO Layer | |
|---|---|
| | Refractive index |
| MgZnO layer | 1.75 to 1.90 |
| ZnO layer | 1.91 to 1.95 |

As shown in Table 2, it was observed that the refractive index of the MgZnO layer was lower than the refractive index of the ZnO layer. For this reason, when the layer made mainly of MgZnO is included in the reflection layer, it is possible to enhance the reflectance of the reflection layer.

### [Evaluation of Contact Resistance Value]

Next, comparison was made between the contact resistance value between a MgZnO layer and a microcrystalline silicon-based semiconductor layer (hereinafter referred to as a µc-Si layer) and the contact resistance value between a ZnO layer and the µc-Si layer.

Specifically, first of all, a test stacked body A in which an Al electrode layer, a µc-Si layer, a MgZnO layer and a Ag electrode layer were sequentially stacked and a test stacked body B in which the Al electrode layer, the µc-Si layer, a ZnO layer and the Ag electrode layer were sequentially stacked were produced. The thickness of the MgZnO layer included in the test stacked body A and the thickness of the ZnO layer included in the test stacked body B were each set at approximately 30 nm. In addition, in both the test stacked body A and the test stacked body B, the thickness of the Al electrode layer was set at approximately 300 nm, the thickness of the µc-Si layer was set at approximately 30 nm, and the thickness of the Ag electrode layer was set at approximately 300 nm.

Thereafter, for each of the test stacked body A and the test stacked body B thus produced, the resistance value between the Al electrode layer and the Ag electrode layer was measured. Table 3 shows a result of measuring the resistance value between the Al electrode layer and the Ag electrode layer in each of the test stacked body A and the test stacked body B.

**[Table 3]**

| Resistance Value between Al Electrode Layer and Ag Electrode Layer in Each of Test Stacked body A and Test Stacked body B | | |
|---|---|---|
| Test Stacked body | Structure | Resistance value (mΩ) |
| A | Al electrode layer/µc-Si layer/MgZnO layer/Ag electrode layer | 27 |
| B | Al electrode layer/µc-Si layer/ZnO layer/Ag electrode layer | 16 |

As shown in Table 3, the resistance value between the Al electrode layer and the Ag electrode layer in the test stacked body A was higher than the resistance value between the Al electrode layer and the Ag electrode layer in the test stacked body B. This shows that the contact resistance value between the MgZnO layer and the µc-Si layer is higher than the contact resistance value between the ZnO layer and the µc-Si layer.

With the result in Table 3 taken into consideration, a test stacked body C in which the Al electrode layer, the µc-Si layer, the ZnO layer, the MgZnO layer and the Ag electrode layer were sequentially stacked was produced, and the resistance value between the Al electrode layer and the Ag electrode layer was measured. In the test stacked body C, the thickness of each of the MgZnO layer and the thickness of the ZnO layer was set at approximately 15 nm. Table 4 shows a result of measuring the resistance value between the Al electrode layer and the Ag electrode layer in the test stacked body C.

**[Table 4]**

| Resistance Value of Al Electrode Layer and Ag Electrode Layer in Test Stacked body C | | |
|---|---|---|
| Test Stacked body | Structure | Resistance value (mΩ) |
| C | Al electrode layer/µc-Si layer/ZnO layer/MgZnO layer/Ag electrode layer | 19 |

As shown in Table 4, it was observed that the resistance value between the Al electrode layer and the Ag electrode layer in the test stacked body C was slightly higher than the resistance value between the Al electrode layer and the Ag electrode layer in the test stacked body B, but far lower than the resistance value between the Al electrode layer and the Ag electrode layer in the test stacked body A.

For this reason, in a case where a layer made mainly of MgZnO is included in the reflection layer, a layer made mainly of ZnO or the like layer, whose contact resistance value with a layer made mainly of silicon is small, should be inserted between the layer made mainly of MgZnO and the layer made mainly of silicon. In this way, it is possible to inhibit increase in the series resistance value of the solar cell.

### [Evaluation of Photoelectric Conversion Efficiency]

Next, solar cells respectively according to Example 1, Example 2, Comparative Example 1, Comparative Example 2 and Comparative Example 3 were produced as follows, and their photoelectric conversion efficiencies were compared.

### <Example 1>

A solar cell 10 according to Example 1 was produced as follows.

First of all, a SnO₂ layer (light-receiving side electrode layer 2) was formed on a glass substrate (substrate 1) with a thickness of 4 mm.

Subsequently, a p-type amorphous silicon-based semiconductor, an i-type amorphous silicon-based semiconductor and an n-type amorphous silicon-based semiconductor were stacked on the SnO₂ layer (light-receiving side electrode layer 2) by plasma CVD. Thereby, a first cell (first photoelectric conversion section 31) was formed.

Thereafter, an intermediate reflection layer (reflection layer 32) was formed on the first cell (first photoelectric conversion section 31) by sputtering. Specifically, the intermediate reflection layer (reflection layer 32) with a three-layered structure was formed by sequentially stacking a ZnO layer (first layer 32a), a MgZnO layer (second layer 32b) and a ZnO layer (third layer 32c) on the first cell (first photoelectric conversion section 31).

Afterward, a p-type microcrystalline silicon-based semiconductor, an i-type microcrystalline silicon-based semiconductor and an n-type microcrystalline silicon-based semiconductor were stacked on the intermediate reflection layer (reflection layer 32) by plasma CVD. Thereby, a second cell (second photoelectric conversion section 33) was formed.

After that, a ZnO layer and a Ag layer (rear side electrode layer 4) were formed on the second cell (second photoelectric conversion section 33) by sputtering.

Table 5 shows conditions for forming the first cell (first photoelectric conversion section 31), the intermediate reflection layer (reflection layer 32) and the second cell (second photoelectric conversion section 33). Note that the thickness of the ZnO layer and the thickness of the Ag layer (rear side electrode layer 4) were respectively set at 90 nm and 200 nm.

**[Table 5]**

| Conditions for Forming First Cell, Intermediate Reflection Layer and Second Cell according to Example 1 | | | | | | |
|---|---|---|---|---|---|---|
| | | Substrate | Gas flow | Reaction | RF power | Thickness |
| | | temperature | rato | pressure | (W) | (mm) |
| | | (°C) | (sccm) | (Pa) | | |
| First cell | | | SiH₄:300 | | | |
| | p-type | 180 | CH₄:300 | 106 | 10 | 15 |
| | | | H₂:2000 | | | |
| | | | B₂H₆:3 | | | |
| | i-type | 200 | SiH₄:300 | 106 | 20 | 200 |
| | | | H₂:2000 | | | |
| | | | SiH₄:300 | | | |
| | n-type | 180 | H₂:2000 | 133 | 20 | 30 |
| | | | PH₃:5 | | | |
| | ZnO layer | | | | | |
| | (first | 170 | Ar:10 | 0.4 | 400 | 5 |
| | layer 32a) | | | | | |
| Intermediate | MgZnO | | | | | |
| reflection | layer | 170 | Ar:10 | 0.4 | 400 | 20 |
| layer | (second | | | | | |
| | layer 32b) | | | | | |
| | ZnO layer (third layer 32c) | 170 | Ar:10 | 0.4 | 400 | 5 |
| | | | SiH₄:10 | | | |
| | p-type | 180 | H₂:2000 | 106 | 10 | 30 |
| | | | B₂H₆:3 | | | |
| Second cell | i-type | 200 | SiH₄:100 | 133 | 20 | 2000 |
| | | | H₂:2000 | | | |
| | | | SiH₄:10 | | | |
| | n-type | 200 | H₂:2000 | 133 | 20 | 20 |
| | | | PH₃:5 | | | |

Thereby, as shown in Fig. 3, the solar cell 10 having the intermediate reflection layer (reflection layer 32), which includes the MgZnO layer (second layer 32b), between the first cell (first photoelectric conversion section 31) and the second cell (second photoelectric conversion section 33) was made for Example 1. In addition, the ZnO layer (first layer 32a) was inserted between the MgZnO layer (second layer 32b) and the first cell (first photoelectric conversion section 31), and the ZnO layer (third layer 32c) was inserted between the MgZnO layer (second layer 32b) and the second cell (second photoelectric conversion section 33).

### <Comparative Example 1>

A solar cell 20 according to Comparative Example 1 was produced as follows.

First of all, as in the case of Example 1, a SnO₂ layer (light-receiving side electrode layer 22) and a first cell (first photoelectric conversion section 231) were sequentially formed on a glass substrate (substrate 21) with a thickness of 4 mm.

Subsequently, an intermediate reflection layer (reflection layer 232) was formed on the first cell (first photoelectric conversion section 231) by sputtering. In the case of Comparative Example 1, only a ZnO layer was formed on the first cell (first photoelectric conversion section 231), and this ZnO layer was used as the intermediate reflection layer (reflection layer 232).

Thereafter, as in the case of Example 1, a second cell (second photoelectric conversion section 233), a ZnO layer and a Ag layer (rear side electrode layer 24) were sequentially formed on the intermediate reflection layer (reflection layer 232).

Table 6 shows conditions for forming the above-described intermediate reflection layer (reflection layer 232). Note that conditions for forming the first cell (first photoelectric conversion section 231) and the second cell (second photoelectric conversion section 233) were the same as the conditions for forming those according to Example 1. In addition, the thickness of the ZnO layer and the thickness of the Ag layer (rear side electrode layer 24) were respectively set at 90 nm and 200 nm as in the case of Example 1.

**[Table 6]**

| Conditions for Forming Intermediate Reflection Layer according to Comparative Example 1 | | | | | | |
|---|---|---|---|---|---|---|
| | | Substrate temperature (°C) | Gas flow rate (sccm) | Reaction pressure (Pa) | RF power (W) | Thickness (mm) |
| Intermediate reflection layer | ZnO layer | 170 | Ar:10 | 0.4 | 400 | 30 |

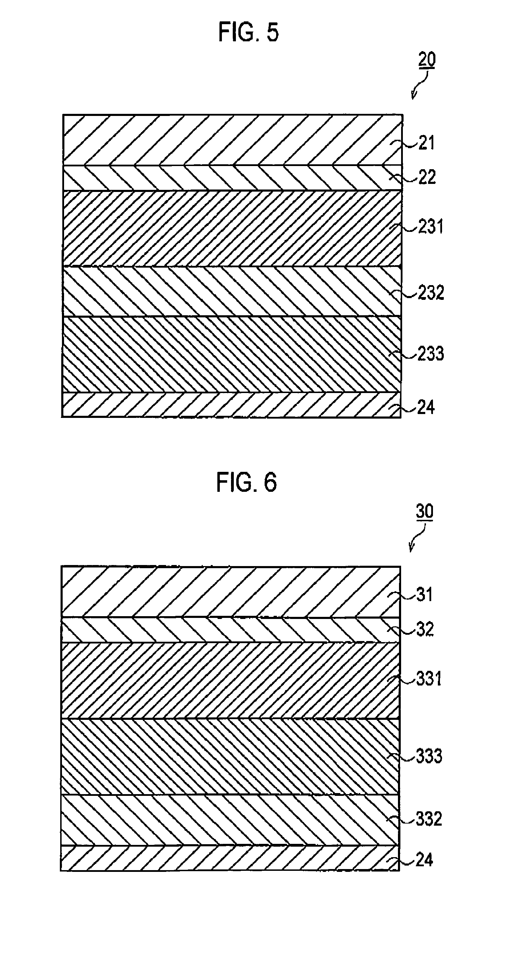

Thereby, as shown in Fig. 5, the solar cell 20 having the intermediate reflection layer (reflection layer 232), which was made of the ZnO layer, between the first cell (first photoelectric conversion section 231) and the second cell (second photoelectric conversion section 233) was formed for Comparative Example 1.

### <Comparative Example 2>

A solar cell 20 according to Comparative Example 2 was produced as follows.

First of all, as in the case of Example 1, a SnO₂ layer (light-receiving side electrode layer 22) and a first cell (first photoelectric conversion section 231) were sequentially formed on a glass substrate (substrate 21) with a thickness of 4 mm.

Subsequently, an intermediate reflection layer (reflection layer 232) was formed on the first cell (first photoelectric conversion section 231) by sputtering. In the case of Comparative Example 2, only a MgZnO layer was formed on the first cell (first photoelectric conversion section 231), and this MgZnO layer was used as the intermediate reflection layer (reflection layer 232).

Thereafter, as in the case of Example 1, a second cell (second photoelectric conversion section 233), a ZnO layer and a Ag layer (rear side electrode layer 24) were sequentially formed on the intermediate reflection layer (reflection layer 232).

Table 7 shows conditions for forming the above-described intermediate reflection layer (reflection layer 232). Note that conditions for forming the first cell (first photoelectric conversion section 231) and the second cell (second photoelectric conversion section 233) were the same as the conditions for forming those according to Example 1. In addition, the thickness of the ZnO layer and the thickness of the Ag layer (rear side electrode layer 24) were respectively set at 90 nm and 200 nm as in the case of Example 1.

**[Table 7]**

| Conditions for Forming Intermediate Reflection Layer according to Comparative Example 2 | | | | | | |
|---|---|---|---|---|---|---|
| | | Substrate temperature (°C) | Gas flow rate (sccm) | Reaction pressure (Pa) | RF power (W) | Thickness (mm) |
| Intermediate reflection layer | MgZnO layer | 170 | Ar:10 | 0.4 | 400 | 30 |

Thereby, as shown in Fig. 5, the solar cell 20 having the intermediate reflection layer (reflection layer 232), which was made of the MgZnO layer, between the first cell (first photoelectric conversion section 231) and the second cell (second photoelectric conversion section 233) was formed for Comparative Example 1.

### <Evaluation of Characteristics (Part 1)>

The solar cells respectively according to Example 1, Comparative Example 1 and Comparative Example 2 were compared in terms of characteristics including an open voltage, a short-circuit current, a fill factor and a photoelectric conversion efficiency. Table 8 shows a result of the comparison. Note that in Table 8, Comparative Example 2 and Example 1 were standardized with Comparative Example 1 whose characteristics were each indexed at 1.00.

**[Table 8]**

| Characteristics of Solar Cells according to Example 1, Comparative Example 1 and Comparative Example 2 | | | | |
|---|---|---|---|---|
| | Open voltage | Short-circuit current | Fill factor | Photoelectric conversion efficiency |
| Comparative example 1 | 1.00 | 1.00 | 1.00 | 1.00 |
| Comparative example 2 | 1.01 | 1.04 | 0.89 | 0.93 |
| Example 1 | 1.00 | 1.04 | 1.00 | 1.04 |

As shown in Table 8, it was observed that the short-circuit current of Comparative Example 2 was larger than that of Comparative Example 1, but the fill factor of Comparative Example 2 was lower than that of Comparative Example 1. As a result, it was observed that the photoelectric conversion efficiency of Comparative Example 2 was lower than that of Comparative Example 1.

One may consider that the solar cell 20 according to Comparative Example 2 has the larger short-circuit current because the intermediate reflection layer (reflection layer 232) is made of the MgZnO layer whose refractive index is lower than that of the ZnO layer. On the other hand, one may consider that the solar cell 20 according to Comparative Example 2 has the lower fill factor because: the MgZnO layer constituting the intermediate reflection layer (reflection layer 232) is in direct contact with the first cell (first photoelectric conversion section 231) and the second cell (second photoelectric conversion section 233); and this direct contact accordingly increases the series resistance value of the solar cell 20 according to Comparative Example 2. Moreover, one may consider the photoelectric conversion efficiency of Comparative Example 2 is lower than that of Comparative Example 1 because the fill factor of Comparative Example 2 was lower than that of Comparative Example 1 to a large extent.

On the contrary, it was observed that the short-circuit current of Example 1 was larger than that of Comparative Example 1 and the value of the fill factor of Example 1 was equivalent to that of Comparative Example 1. As a result, it was confirmed that the photoelectric conversion efficiency of Example 1 was able to be made higher than that of Comparative Example 1.

### <Example 2>

A solar cell 10 according to Example 2 was produced as follows.

First of all, a SnO₂ layer (light-receiving side electrode layer 2) was formed on a glass substrate (substrate 1) with a thickness of 4 mm.

Subsequently, a p-type amorphous silicon-based semiconductor, an i-type amorphous silicon-based semiconductor and an n-type amorphous silicon-based semiconductor were stacked on the SnO₂ layer (light-receiving side electrode layer 2) by plasma CVD. Thereby, a first cell (first photoelectric conversion section 31) was formed.

Thereafter, a p-type microcrystalline silicon-based semiconductor, an i-type microcrystalline silicon-based semiconductor and an n-type microcrystalline silicon-based semiconductor were stacked on the first cell (first photoelectric conversion section 31) by plasma CVD. Thereby, a second cell (second photoelectric conversion section 33) was formed.

Afterward, an intermediate reflection layer (reflection layer 32) was formed on the second cell (second photoelectric conversion section 33) by sputtering. Specifically, a rear side reflection layer (reflection layer 32) with a two-layered structure was formed by sequentially stacking an ITO layer (first layer 32a) and a MgZnO layer (second layer 32b) on the second cell (second photoelectric conversion section 33).

After that, a Ag layer (rear side electrode layer 4) was formed on the rear side reflection layer (reflection layer 32) by sputtering.

Table 9 shows conditions for forming the first cell (first photoelectric conversion section 31), the second cell (second photoelectric conversion section 33) and the rear side reflection layer (reflection layer 32). Note that the thickness of the Ag layer (rear side electrode layer 4) was set at 200 nm.

**[Table 9]**

| Conditions for Forming First Cell, Second Cell and Rear Side Reflection Layer according to Example 2 | | | | | | |
|---|---|---|---|---|---|---|
| | | Substrate temperature (°C) | Gas flow rate (sccm) | Reaction pressure (Pa) | RF power (W) | Thickness (mm) |
| First cell | | | SiH₄:300 | | | |
| | p-type | 180 | CH₄:300 | 106 | 10 | 15 |
| | | | H₂:2000 | | | |
| | | | B₂H₆:3 | | | |
| | i-type | 200 | SiH₄:300 | 106 | 20 | 360 |
| | | | H₂:2000 | | | |
| | | | SiH₄:300 | | | |
| | n-type | 180 | H₂:2000 | 133 | 20 | 30 |
| | | | PH₃:5 | | | |
| Second cell | | | SiH₄:10 | | | |
| | p-type | 180 | H₂:2000 | 106 | 10 | 30 |
| | | | B₂H₆:3 | | | |
| | i-type | 200 | SiH₄:100 | 133 | 20 | 2000 |
| | | | H₂:2000 | | | |
| | | | SiH₄:10 | | | |
| | n-type | 200 | H₂:2000 | 133 | 20 | 20 |
| | | | PH₃:5 | | | |
| Rear side reflection layer | ITO layer | | Ar:10 | | | |
| | (first | 170 | O₂:0.1 | 0.4 | 400 | 45 |
| | layer 32a) | | | | | |
| | MgZnO layer (second layer 32b) | 170 | Ar:10 | 0.4 | 400 | 45 |

Thereby, as shown in Fig. 2, the solar cell 10 having the rear side reflection layer (reflection layer 32), which includes the MgZnO layer (second layer 32b), between the second cell (second photoelectric conversion section 33) and the Ag layer (rear side electrode layer 4) was made for Example 1. In addition, the ITO layer (first layer 32a) was inserted between the MgZnO layer (second layer 32b) and the second cell (second photoelectric conversion section 33).

### <Comparative Example 3>

A solar cell 30 according to Comparative Example 3 was produced as follows.

First of all, as in the case of Example 2, a SnO₂ layer (light-receiving side electrode layer 32), a first cell (first photoelectric conversion section 331) and a second cell (second photoelectric conversion section 333) were sequentially formed on a glass substrate (substrate 31) with a thickness of 4 mm.

Subsequently, a rear side reflection layer (reflection layer 332) was formed on the second cell (second photoelectric conversion section 333) by sputtering. In the case of Comparative Example 3, only a ZnO layer was formed on the second cell (second photoelectric conversion section 333), and this ZnO layer was used as the rear side reflection layer (reflection layer 332).

Thereafter, as in the case of Example 1, a Ag layer (rear side electrode layer 34) was formed on the rear side reflection layer (reflection layer 332).

Table 10 shows conditions for forming the above-described rear side reflection layer (reflection layer 332). Note that conditions for forming the first cell (first photoelectric conversion section 331) and the second cell (second photoelectric conversion section 333) were the same as the conditions for forming those according to Example 2. In addition, the thickness of the Ag layer (rear side electrode layer 34) was set at 200 nm as in the case of Example 2.

**[Table 10]**

| Conditions for Forming Rear Side Reflection Layer according to Comparative Example 3 | | | | | | |
|---|---|---|---|---|---|---|
| | | Substrate temperature (°C) | Gas flow rate (sccm) | Reaction Pressure (Pa) | RF power (W) | Thickness (mm) |
| Rear side reflection layer | ZnO layer | 170 | Ar:10 | 0.4 | 300 | 90 |

Thereby, as shown in Fig. 6, the solar cell 10 having the rear side reflection layer (reflection layer 332), which was made of the ZnO layer, between the second cell (second photoelectric conversion section 333) and the Ag layer (rear side electrode layer 34) was formed for Comparative Example 3.

### <Evaluation of Characteristics (Part 2)>

The solar cells respectively according to Example 2 and Comparative Example 3 were compared in terms of characteristics including an open voltage, a short-circuit current, a fill factor and a photoelectric conversion efficiency. Table 11 shows a result of the comparison. Note that in Table 11, Example 2 was standardized with Comparative Example 3 whose characteristics were each indexed at 1.00.

**[Table 11]**

| Characteristics of Solar Cells according to Example 2 and Comparative Example 3 | | | | |
|---|---|---|---|---|
| | Open voltage | Short-circuit current | Fill factor | Photoelectric conversion efficiency |
| Comparative example 3 | 1.00 | 1.00 | 1.00 | 1.00 |
| Example 2 | 1.00 | 1.02 | 1.00 | 1.02 |

As shown in Table 11, it was observed that the short-circuit current of Example 2 was larger than that of Comparative Example 3, and the value of the fill factor of Example 2 was able to be equivalent to that of Comparative Example 3. As a result, it was confirmed that the photoelectric conversion efficiency of Example 2 was able to be made higher than that of Comparative Example 1.

### [Optimization of Mg Content]

### <Measurement of Light Absorption Coefficient>

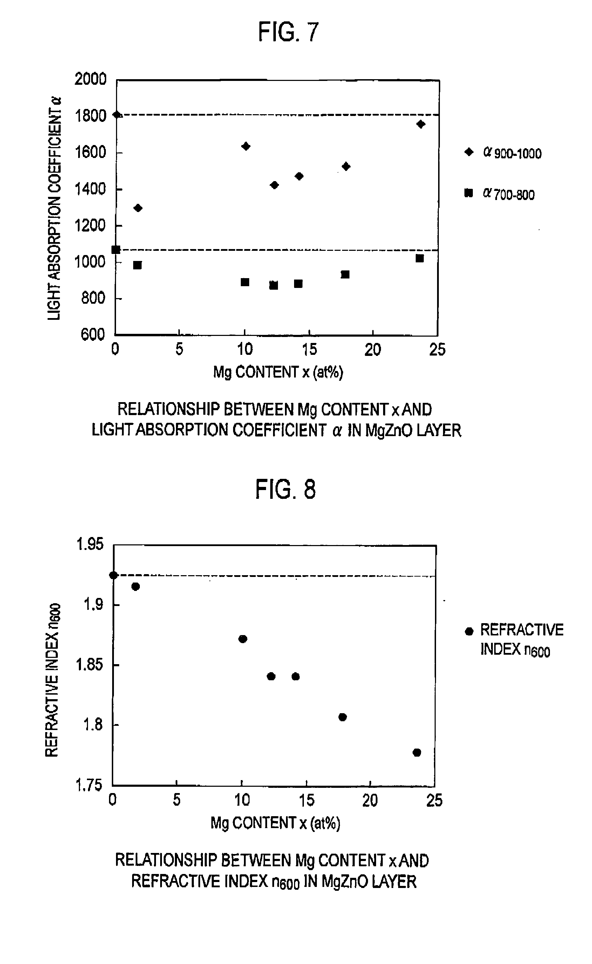

Next, a Mg content (a ratio of Mg to Zn, Mg and O) of the MgZnO layer was made optimal. Specifically, multiple MgZnO layers whose Mg contents were different from one another in a range of 0at% to 40at% were produced. For each MgZnO layer, the Mg content was measured by X-ray photoelectron spectroscopy (XPS), and the light absorption coefficient was measured. Note that each MgZnO layer was produced by sputtering, and the thickness of each MgZnO layer was set at approximately 100 nm. Fig. 7 shows a relationship between the Mg content and the light absorption coefficient of each MgZnO layer. As the light absorption coefficients, an average value α700-800 of light absorption coefficients in a wave range of 700 to 800 nm and an average value α900-1000 of light absorption coefficients in a wave range of 900 to 1000 nm were for each MgZnO layer. Note that in Fig. 7, points at which a Mg content x is 0 represent the light absorption coefficient α700-800 and the light absorption coefficient α900-1000 of the ZnO layer, respectively.

As shown in Fig. 7, when the Mg content x was larger than 0at% but not larger than 25at% (or 0<x≤25 (at%)), it was observed that: the light absorption coefficient α700-800 of each MgZnO layer was smaller than the light absorption coefficient α700-800 of the ZnO layer; and the light absorption coefficient α900-1000 of each MgZnO layer was smaller than the light absorption coefficient α900-1000 of the ZnO layer. That the light absorption coefficient α700-800 of the MgZnO layer is smaller than the light absorption coefficient α700-800 of the ZnO layer means that the MgZnO layer transmits therethrough light in the wave range of 700 to 800 nm more easily than the ZnO layer. In addition, that the light absorption coefficient α900-1000 of the MgZnO layer is smaller than the light absorption coefficient α900-1000 of the ZnO layer means that the MgZnO layer transmits therethrough light in the wave range of 900 to 1000 nm more easily than the ZnO layer.

For this reason, when the Mg content of the MgZnO layer included in the intermediate reflection layer is set larger than 0at% but not larger than 25at% (or 0<x≤25(at%)), the amount of light, which is incident on the second cell after being transmitted through the intermediate reflection layer, is large, as compared to the case of using an intermediate reflection layer containing no MgZnO (for instance, the intermediate reflection layer according to Comparative Example 1). Thus, it is possible to increase the short-circuit current of the solar cell. Accordingly, the photoelectric conversion efficiency of the solar cell can be further enhanced.

### <Measurement of Refractive Index>

Under the condition that the Mg content of the MgZnO layer was larger than 0at% but not larger than 25at% (or 0<x≤25 (at%)), the refractive index of the MgZnO layer was measured as a confirmation experiment. Fig. 8 shows a relationship between the Mg content and the refractive index in each MgZnO layer. Here, a value n600 at a wavelength of 600 nm was used as the value of the refractive index. Note that in Fig. 8, a point at which the Mg content is 0 represents the refractive index of the ZnO layer.

As shown in Fig. 8, when the Mg content of the MgZnO layer was larger than 0at% but not larger than 25at% (or 0<x≤25 (at%)), it was observed that the refractive index of the MgZnO layer was lower than the refractive index of the ZnO layer. Accordingly, it was confirmed that, when the Mg content of the MgZnO layer included in the intermediate reflection layer was larger than 0at% but not larger than 25at% (or 0<x≤25(at%)), the amount of light, which is reflected to the first cell by the intermediate reflection layer, as well as the amount of light, which is transmitted through the intermediate reflection layer to the second cell, are large, as compared to the case of using an intermediate reflection layer containing no MgZnO (for instance, the intermediate reflection layer according to Comparative Example 1).

### INDUSTRIAL APPLICABILITY

As described above, the present invention can provide a solar cell whose photoelectric conversion efficiency is enhanced, and is accordingly useful in the field of solar cell power generation.

## Claims

1. A solar cell comprising:
a light-receiving side electrode layer which is electrically-conductive and transparent;
a rear side electrode layer which is electrically-conductive; and
a stacked body placed between the light-receiving side electrode layer and the rear side electrode layer, wherein
the stacked body includes a first photoelectric conversion section configured to generate photo-generated carriers on the basis of light incident thereon, and a reflection layer configured to reflect part of light, which is transmitted through the first photoelectric conversion section, to the first photoelectric conversion section side, and
the reflection layer includes a low-refractive-index layer and a contact layer inserted between the low-refractive-index layer and the first photoelectric conversion section.

2. The solar cell according to claim 1, wherein
the stacked body has a configuration in which the first photoelectric conversion section, the reflection layer and a second photoelectric conversion section are sequentially stacked from the light-receiving side electrode layer side, the second photoelectric conversion section being configured to generate photo-generated carriers on the basis of light incident thereon, and
the reflection layer further includes a different contact layer which is inserted between the low-refractive-index layer and the second photoelectric conversion section.

3. The solar cell according to any one of claims 1 and 2, wherein the contact layer is made of a material which makes a contact resistance value between the contact layer and the first photoelectric conversion section smaller than a contact resistance value between the low-refractive-index layer and the first photoelectric conversion section.

4. The solar cell according to claim 2, wherein the different contact layer is made of a material which makes a contact resistance value between the different contact layer and the second photoelectric conversion section smaller than a contact resistance value between the low-refractive-index layer and the second photoelectric conversion section.

5. The solar cell according to any one of claims 1 to 4, wherein the low-refractive-index layer is made of a transparent electrically-conductive oxide whose refractive index is not less than 1.7 but not more than 1.9.

6. The solar cell according to claim 5, wherein the low-refractive-index layer is made of a transparent electrically-conductive oxide whose refractive index is not less than 1.7 but not more than 1.85.

7. The solar cell according to any one of claims 1 to 6, wherein the low-refractive-index layer is made of MgZnO.

8. The solar cell according to claim 1, wherein the contact layer contains any one of zinc oxide and indium oxide.

9. The solar cell according to claim 2, wherein the different contact layer contains any one of zinc oxide and indium oxide.

10. A solar cell which includes a first solar cell element and a second solar cell element on a substrate which is electrically-insulating and transparent, wherein
each of the first solar cell element and the second solar cell element includes
a light-receiving side electrode layer which is electrically-conductive and transparent,
a rear side electrode layer which is electrically-conductive, and
a stacked body placed between the light-receiving side electrode layer and the rear side electrode layer,
the stacked body includes
a first photoelectric conversion section configured to generate photo-generated carriers on the basis of light incident thereon,
a reflection layer configured to reflect part of light, which is transmitted through the first photoelectric conversion section, to the first photoelectric conversion section side, and
a second photoelectric conversion section configured to generate photo-generated carriers on the basis of light incident thereon,
the rear side electrode layer of the first solar cell element includes an extension section which extends to the light-receiving side electrode layer of the second solar cell element,
the extension section is formed along a side surface of the stacked body included in the first solar cell element,
the extension section is in contact with the reflection layer which is exposed from the side surface of the stacked body included in the first solar cell element, and
the reflection layer includes
a low-refractive-index layer,
a contact layer inserted between the low-refractive-index layer and the first photoelectric conversion section, and
a different contact layer inserted between the low-refractive-index layer and the second photoelectric conversion section.

11. The solar cell according to claim 10 wherein the contact layer has a thickness which is less than that of the low-refractive-index layer.

12. The solar cell according to any one of claims 10 and 11, wherein the low-refractive-index layer is made of MgZnO.

13. The solar cell according to any one of claims 7 and 12, wherein a Mg content of the MgZnO layer is larger than 0at% but not larger than 25at%.

## Amended claims

### Amended claims under Art. 19.1 PCT

**1.** (Amended)
A solar cell comprising:
a light-receiving side electrode layer which is electrically-conductive and transparent;
a rear side electrode layer which is electrically-conductive; and
a stacked body placed between the light-receiving side electrode layer and the rear side electrode layer, wherein
the stacked body includes a first photoelectric conversion section configured to generate photo-generated carriers on the basis of light incident thereon, and a reflection layer configured to reflect part of light, which is transmitted through the first photoelectric conversion section, to the first photoelectric conversion section, and
the reflection layer includes a low-refractive-index layer made of MgZnO and a contact layer inserted between the low-refractive-index layer and the first photoelectric conversion section.

**2.** The solar cell according to claim 1, wherein
the stacked body has a configuration in which the first photoelectric conversion section, the reflection layer and a second photoelectric conversion section are sequentially stacked from the light-receiving side electrode layer side, the second photoelectric conversion section being configured to generate photo-generated carriers on the basis of light incident thereon, and
the reflection layer further includes a different contact layer which is inserted between the low-refractive-index layer and the second photoelectric conversion section.

**3.** (Amended)
The solar cell according to any one of claims 1, wherein the contact layer is made of a material which makes a contact resistance value between the contact layer and the first photoelectric conversion section smaller than a contact resistance value between the low-refractive-index layer and the first photoelectric conversion section.

**4.** The solar cell according to claim 2, wherein the different contact layer is made of a material which makes a contact resistance value between the different contact layer and the second photoelectric conversion section smaller than a contact resistance value between the low-refractive-index layer and the second photoelectric conversion section.

**5.** (Amended)
The solar cell according to any one of claims 1, wherein the low-refractive-index layer is made of a transparent electrically-conductive oxide whose refractive index is not less than 1.7 but not more than 1.9.

**6.** The solar cell according to claim 5, wherein the low-refractive-index layer is made of a transparent electrically-conductive oxide whose refractive index is not less than 1.7 but not more than 1.85.

**7.** (Canceled)

**8.** The solar cell according to claim 1, wherein the contact layer contains any one of zinc oxide and indium oxide.

**9.** The solar cell according to claim 2, wherein the different contact layer contains any one of zinc oxide and indium oxide.

**10.** (Amended)
A solar cell which includes a first solar cell element and a second solar cell element on a substrate which is electrically-insulating and transparent, wherein
each of the first solar cell element and the second solar cell element includes
a light-receiving side electrode layer which is electrically-conductive and transparent,
a rear side electrode layer which is electrically-conductive, and
a stacked body placed between the light-receiving side electrode layer and the rear side electrode layer,
the stacked body includes
a first photoelectric conversion section configured to generate photo-generated carriers on the basis of light incident thereon,
a reflection layer configured to reflect part of light, which is transmitted through the first photoelectric conversion section, to the first photoelectric conversion section, and
a second photoelectric conversion section configured to generate photo-generated carriers on the basis of light incident thereon,
the rear side electrode layer of the first solar cell element includes an extension section which extends to the light-receiving side electrode layer of the second solar cell element,
the extension section is formed along a side surface of the stacked body included in the first solar cell element,
the extension section is in contact with the reflection layer which is exposed from the side surface of the stacked body included in the first solar cell element, and
the reflection layer includes
a low-refractive-index layer,
a contact layer inserted between the low-refractive-index layer made of MgZnO and the first photoelectric conversion section, and
a different contact layer inserted between the low-refractive-index layer and the second photoelectric conversion section.

**11.** The solar cell according to claim 10 wherein the contact layer has a thickness which is less than that of the low-refractive-index layer.

**12.** (Canceled)

**13.** (Amended)
The solar cell according to any one of claims 10, wherein a Mg content of the MgZnO layer is larger than 0at% but not larger than 25at%.

**14.** (New)
The solar cell according to any one of claims 1, wherein a Mg content of the MgZnO layer is larger than 0at% but not larger than 25at%.
